(19) Europäisches Patentamt
European Patent Office
Office européen des brevets

(11) **EP 2 591 373 B1**

(12) **EUROPÄISCHE PATENTSCHRIFT**

(45) Veröffentlichungstag und Bekanntmachung des Hinweises auf die Patenterteilung:
**04.06.2014 Patentblatt 2014/23**

(21) Anmeldenummer: **10742778.3**

(22) Anmeldetag: **09.07.2010**

(51) Int Cl.:
*G01R 31/02* (2006.01)    *G01R 31/08* (2006.01)
*H02H 3/40* (2006.01)    *H02H 3/44* (2006.01)
*H02H 7/26* (2006.01)    *H02H 1/00* (2006.01)

(86) Internationale Anmeldenummer:
**PCT/EP2010/059929**

(87) Internationale Veröffentlichungsnummer:
**WO 2012/003888 (12.01.2012 Gazette 2012/02)**

(54) **SCHNELLER DISTANZSCHUTZ FÜR ENERGIEVERSORGUNGSNETZE**

FAST DISTANCE PROTECTION FOR ENERGY SUPPLY NETWORKS

PROTECTION DE DISTANCE RAPIDE POUR DES RÉSEAUX D'ALIMENTATION EN ÉNERGIE

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(43) Veröffentlichungstag der Anmeldung:
**15.05.2013 Patentblatt 2013/20**

(73) Patentinhaber: **Siemens Aktiengesellschaft
80333 München (DE)**

(72) Erfinder:
• **BLUMSCHEIN, Jörg
14165 Berlin (DE)**
• **DZIENIS, Cezary
14624 Dallgow-Döberitz (DE)**
• **KEREIT, Matthias
12159 Berlin (DE)**

(56) Entgegenhaltungen:
**JP-A- 2008 187 825    US-A1- 2003 055 585
US-B1- 6 601 001**

• **GABRIEL BENMOUYAL ET AL: "A Combined Directional and Faulted Phase Selector Element Based on Incremental Quantities", IEEE TRANSACTIONS ON POWER DELIVERY, IEEE SERVICE CENTER, NEW YORK, NY, US, Bd. 16, Nr. 4, 1. Oktober 2001 (2001-10-01), XP011050079, ISSN: 0885-8977**
• **JIAN-CHENG TAN ET AL: "Sensitivity and Stability of Superimposed Component Based Directional Comparison Protection", ELECTRICAL AND COMPUTER ENGINEERING, 2007. CCECE 2007. CANADIAN CONFER ENCE ON, IEEE, PI, 1. April 2007 (2007-04-01), Seiten 280-283, XP031176520, ISBN: 978-1-4244-1020-0**

**Beschreibung**

Die Erfindung betrifft ein Verfahren zum Erkennen eines Kurzschlusses auf einer Leitung eines mehrphasigen elektrischen Energieversorgungsnetzes mit geerdetem Sternpunkt, bei dem Strom- und Spannungsabtastwerte an einer Messstelle an einem Ende der überwachten Leitung durch ein elektrisches Schutzgerät aufgenommen werden und ein einen Kurzschluss auf der Leitung angebendes erstes Fehlersignal erzeugt wird, wenn eine von dem elektrischen Schutzgerät durchgeführte Fehlerauswertung der Strom- und Spannungsabtastwerte auf einen auf der Leitung vorhandenen Kurzschluss hinweist. Die Erfindung bezieht sich auch auf ein entsprechend eingerichtetes elektrisches Schutzgerät.

In elektrischen Energieversorgungsnetzen mit geerdetem Sternpunkt muss bei eindeutigen Kurzschlüssen eine besonders schnelle Abschaltung der fehlerbehafteten Leitung ermöglicht werden. Aufgrund der hohen Kurzschlussleistung sind in solchen Energieversorgungsnetzen Kurzschlüsse besonders gefährlich, weil sie zum einen Betriebsmittel des Energieversorgungsnetzes wie Leitungen, Transformatoren, Kompensationsanlagen, Generatoren usw. stark thermisch beanspruchen und zum anderen einen "unstabilen", oszillatorischen Betrieb mit sogenannten elektrischen Pendelungen verursachen können. Diese beiden Effekte können zu einem dauerhaften Netzausfall (einem sogenannten "Blackout") führen, so dass die Energielieferung in bestimmten Netzgebieten nicht mehr gewährleistet wird. Um den sicheren Betrieb eines Energieversorgungsnetzes zu gewährleisten ist daher eine schnelle Abschaltung des Kurzschlusses auf der fehlerbehafteten Leitung von großem Belang.

Eine der grundlegenden Schutzmethoden zur automatischen Überwachung von Leitungen elektrischer Energieversorgungsnetze ist die sogenannte Distanzschutzmethode. Ein häufig im Rahmen des Distanzschutzes eingesetzter Algorithmus zum Erkennen eines Kurzschlusses auf einer Leitung basiert auf der Messung einer sogenannten Kurzschlussimpedanz. Schutzgeräte messen hierbei die Impedanz bis zum Fehlerort und schließen damit auf die Entfernung (Distanz) zum Fehlerort. Die Kurzschlussimpedanz (umgerechnet auf die Fehlerdistanz) wird verwendet, um festzustellen, ob der erfasste Kurzschluss tatsächlich auf der zu schützenden Leitung liegt. Dazu müssen die Länge der Leitung sowie deren Impedanzbelag bekannt sein. Wenn festgestellt wird, dass der Kurzschluss auf der zu schützenden Leitung liegt, wird die betroffene Leitung abgeschaltet und der fehlerbehaftete Netzabschnitt vom System getrennt. Dadurch wird der weitere konforme Betrieb des Netzes gewährleistet.

Zur Durchführung dieses Distanzschutzalgorithmus werden an Messstellen an jedem Ende der überwachten Leitung Strom- und Spannungssignale abgetastet und ausgewertet. Daraufhin müssen die zeitlichen Größen in komplexe Größen umgewandelt werden. Das erfolgt mit speziell für diese Aufgabe ausgelegten Filtern, die die unerwünschten Störsignale (z.B. DC-Anteile) eliminieren und den Real- und Imaginärteil der Strom- bzw. Spannungszeiger liefern. Vereinfacht lässt sich die Kurzschlussimpedanz auf der Basis der komplexen Größen als Quotient aus der komplexen Spannung und dem komplexen Strom berechnen. Ist diese Kurzschlussimpedanz kleiner als die bekannte Leitungsimpedanz, dann liegt ein interner Fehler in der überwachten Schutzzone der Leitung vor.

Die Distanzmessung kann ferner auch mit Hilfe von komplexen "Delta-Größen" von Strom und Spannung durchgeführt werden. Diese Delta-Größen können durch den Vergleich von vor dem Kurzschluss erfassten Messwerten mit solchen, die während des Kurzschlusses aufgenommen werden ermittelt werden. Hierbei wird quasi der durch den Kurzschluss auf der Leitung erzeugte Anteil des Strom- und Spannungsverlaufs ausgewertet.

Beispielsweise offenbart die JP 2008187825 A ein Distanzschutzverfahren, bei dem vor und während des Fehlers aufgenommene momentane Spannungswerte verwendet werden.

Beide beschriebenen Methoden haben den Nachteil, dass für die Berechnung der komplexen Strom- und Spannungswerte abhängig von der Größe des verwendeten Messfensters eine Mindestanzahl von Abtastwerten vonnöten ist, so dass eine Entscheidung über das Vorliegen eines Kurzschlusses auf der Leitung erst mit einer gewissen Verzögerung getroffen werden kann.

Der Erfindung liegt daher die Aufgabe zugrunde, ein Verfahren und ein entsprechendes Schutzgerät derart anzugeben, dass insbesondere bei eindeutigen Fehlern auf einer überwachten Leitung ein Fehlersignal noch schneller als bisher erzeugt werden kann.

Zur Lösung dieser Aufgabe hinsichtlich des Verfahrens wird ein Verfahren der eingangs angegebenen Art derart ausgebildet, dass zur Fehlerauswertung der Strom- und Spannungsabtastwerte momentane Referenzspannungswerte für eine Referenzstelle auf der Leitung aus vor Eintritt des Kurzschlusses aufgenommenen momentanen Strom- und Spannungsabtastwerten und momentane Vergleichsspannungswerte für die Referenzstelle auf der Leitung aus vor Eintritt des Kurzschlusses aufgenommenen momentanen Strom- und Spannungsabtastwerten und während des Fehlers aufgenommenen momentanen Strom- und Spannungsabtastwerten berechnet werden. Aus aufeinander folgenden momentanen Referenzspannungswerten wird daraufhin ein gleichgerichteter Referenzspannungswert und aus aufeinander folgenden momentanen Vergleichsspannungswerten ein gleichgerichteter Vergleichsspannungswert berechnet. Der gleichgerichtete Referenzspannungswert wird mit dem gleichgerichteten Vergleichsspannungswert verglichen und es wird ein erstes Fehlersignal erzeugt, wenn die Differenz aus dem gleichgerichteten Vergleichsspannungswert und dem gleichgerichteten Referenzspannungswert einen Auslöseschwellenwert übersteigt, wobei die Berechnung der momentanen Referenzspannungswerte gemäß folgender Gleichung erfolgt:

$$u_{ref}(n) = u_p(n) - L_{ref}\frac{i_p(n) - i_p(n-1)}{T} - R_{ref} \cdot i_p(n) \,,$$

mit

$u_{ref}(n)$     : momentaner Referenzspannungswert;
$u_p(n) = u(n-N)$ : Vorfehler-Spannungsabtastwert eine Periodendauer vor dem momentanen Spannungabtastwert u(n);
$i_p(n) = i(n-N)$ : Vorfehler-Stromabtastwert eine Periodendauer vor dem momentanen Stromabtastwert i(n);
T     : Periodendauer;
N     : Anzahl der Abtastwerte pro Periodendauer;
n     : Nummer des Abtastwertes nach Fehlereintritt;
$L_{ref}$     : Induktivität der Leitung von der Messstelle zur Referenzstelle;
$R_{ref}$     : Resistanz der Leitung von der Messstelle zur Referenzstelle;

die Berechnung der momentanen Vergleichsspannungswerte gemäß folgender Gleichung erfolgt:

$$u_V(n) = \Delta u_f(n) - L_{ref}\frac{\Delta i_f(n) - \Delta i_f(n-1)}{T} - R_{ref} \cdot \Delta i_f(n) \,,$$

mit

$u_v(n)$     : momentaner Vergleichsspannungswert;
$\Delta u_f(n)$     : momentaner Delta-Spannungswert nach Fehlereintritt;
$\Delta i_f(n)$     : momentaner Delta-Stromwert nach Fehlereintritt;
$L_{ref}$     : Induktivität der Leitung von der Messstelle zur Referenzstelle;
$R_{ref}$     : Resistanz der Leitung von der Messstelle zur Referenzstelle;
T     : Periodendauer;
n     : Nummer des Abtastwertes nach Fehlereintritt;

die momentanen Delta-Spannungswerte gemäß der folgenden Gleichung ermittelt werden:

$$\Delta u_f(n) = u(n) - u_p(n)$$

mit

$\Delta u_f(n)$     : momentaner Delta-Spannungswert nach Fehlereintritt;
u(n)     : momentaner Spannungsabtastwert nach Fehlereintritt;
$u_p(n) = u(n-N)$ : Vorfehler-Spannungsabtastwert eine Periodendauer vor dem momentanen Spannungsabtastwert u(n);
n     : Nummer des Abtastwertes nach Fehlereintritt;

N    : Anzahl der Abtastwerte pro Periodendauer

und die momentanen Delta-Stromwerte gemäß der folgenden Gleichung ermittelt werden:

$$\Delta i_f(n) = i(n) - i_p(n)$$

mit

$\Delta i_f(n)$       : momentaner Delta-Stromwert nach Fehlereintritt;
$i(n)$          : momentaner Stromabtastwert nach Fehlereintritt;
$i_p(n) = i(n-N)$   : Vorfehler-Stromabtastwert eine Periodendauer vor dem momentanen Stromabtastwert i(n);
$n$           : Nummer des Abtastwertes nach Fehlereintritt;
$N$          : Anzahl der Abtastwerte pro Periodendauer, und wobei

die Berechnung des gleichgerichteten Referenzspannungswertes gemäß folgender Gleichung erfolgt:

$$U_{ref}(n) = \frac{2}{N} \sum_{k=n-(\frac{N}{2}-1)}^{n} \left( \left| u_{ref}(k) \right| \right),$$

mit

$U_{ref}(n)$     gleichgerichteter Referenzspannungswert;
$u_{ref}(k)$     : momentaner Referenzspannungswert für den Abtastwert k;
$n$          : Nummer des Abtastwertes nach Fehlereintritt;
$N$          : Anzahl der Abtastwerte pro Periodendauer;
$k$          : Aufsummierungsindex

und die Berechnung des gleichgerichteten Vergleichsspannungswertes gemäß folgender Gleichung erfolgt:

$$U_V(n) = \frac{2}{N} \sum_{k=n-(\frac{N}{2}-1)}^{n} \left( \left| u_V(k) \right| \right)$$

mit

$U_V(n)$     : gleichgerichteter Vergleichsspannungswert;
$u_V(k)$     : momentaner Vergleichsspannungswert für den Abtastwert k;
$n$          : Nummer des Abtastwertes nach Fehlereintritt;
$N$          : Anzahl der Abtastwerte pro Periodendauer;
$k$          : Aufsummierungsindex.

Ein besonderer Vorteil des erfindungsgemäßen Verfahrens besteht darin, dass durch die Verwendung von Momentanwerten (anstelle komplexer Werte) für die Referenzspannungswerte und die Vergleichsspannungswerte eine sehr schnelle Entscheidung über das Vorliegen eines Kurzschlusses auf der Leitung getroffen werden kann, da nicht erst die vollständige Länge eines verwendeten Messfensters abgewartet werden muss. Da aus diesen Momentanwerten daraufhin gleichgerichtete Werte erzeugt werden, kann die Gefahr einer Fehlentscheidung aufgrund einzelner Messfehler oder Ausreißer bei den Abtastwerten von Strom und Spannung verhindert werden.

Durch die Verwendung des erfindungsgemäßen Verfahrens kann bei stromstarken Kurzschlüssen auf der Leitung bereits nach wenigen Millisekunden ein entsprechendes Fehlersignal gebildet werden. Da das Verfahren ausschließlich mit an der lokalen Messstelle erfassten Strom- und Spannungsabtastwerten arbeitet, ist eine Kommunikation mit anderen Schutzgeräten (beispielsweise am anderen Leitungsende) nicht notwendig.

Die Referenzspannungswerte können allein anhand der vor Eintritt des Fehlers erfassten Abtastwerte und bekannter Leitungsparameter ermittelt werden.

Die Vergleichswerte können anhand von Delta-Größen für Ströme und Spannungen und der bekannten Leitungsparameter ermittelt werden.

Die Delta-Größen können anhand der vor dem Kurzschluss und während des Kurzschlusses aufgenommenen Abtastwerte berechnet werden.

Als besonders vorteilhaft wird es angesehen, wenn als Referenzstelle das Ende einer von dem Schutzgerät überwachten Überwachungszone auf der Leitung verwendet wird.

Bei dieser vorteilhaften Weiterbildung des erfindungsgemäßen Verfahrens kann das Fehlersignal sehr einfach für die komplette überwachte Überwachungs- bzw. Schutzzone auf der Leitung ermittelt werden (beispielsweise 85 % der Leitungslänge, ausgehend von der Messstelle, an der sich das betreffende Schutzgerät befindet).

Eine weitere vorteilhafte Ausführungsform des erfindungsgemäßen Verfahrens sieht vor, dass das Schutzgerät den Beginn eines Kurzschlusses erkennt, wenn die aufgenommenen Stromabtastwerte einen Stromsprung aufweisen, der einen Sprungschwellenwert übersteigt, ein erstes Anregesignal erzeugt wird, wenn das Schutzgerät den Beginn eines Kurzschlusses erkannt hat, und das Schutzgerät erst nach Vorliegen des ersten Anregesignals mit der Fehlerauswertung der Strom- und Spannungsabtastwerte beginnt.

Auf diese Weise kann das erfindungsgemäße Verfahren besonders Ressourcen schonend durchgeführt werden, da die Fehlerauswertung der Strom- und Spannungsabtastwerte erst dann initiiert wird, wenn das Schutzgerät anhand eines Stromsprungs das Vorliegen eines Kurzschlusses auf der Leitung detektiert hat, und andernfalls keine weitere Rechenleistung für die Auswertung der Strom- und Spannungsabtastwerte aufgewendet werden muss.

In diesem Zusammenhang sieht eine weitere vorteilhafte Ausführungsform des erfindungsgemäßen Verfahrens vor, dass das Schutzgerät bei vorliegendem ersten Anregesignal zunächst eine Untersuchung der Strom- und Spannungsabtastwerte dahingehend durchführt, hinsichtlich welcher Phasenleiter der Leitung der Kurzschluss aufgetreten ist, ein zweites Anregesignal erzeugt wird, das zumindest einen von dem Kurzschluss betroffenen Phasenleiter angibt, und das Schutzgerät die Fehlerauswertung nur hinsichtlich des zumindest einen von dem zweiten Anregesignal angegebenen Phasenleiters durchführt.

Hierdurch kann das Verfahren noch Ressourcen schonender ausgeführt werden, da eine Fehlerauswertung der Strom- und Spannungsabtastwerte lediglich hinsichtlich der tatsächlich von dem Kurzschluss behafteten Fehlerschleife durchgeführt wird.

Eine weitere vorteilhafte Ausführungsform des erfindungsgemäßen Verfahrens sieht vor, dass der Auslöseschwellenwert derart dynamisch festgelegt wird, dass mit steigender Anzahl der für die Berechnung des gleichgerichteten Vergleichsspannungswertes herangezogenen Strom- und Spannungsabtastwerte der Wert des Auslöseschwellenwertes zumindest in Stufen abnimmt.

Hierdurch kann die Empfindlichkeit des erfindungsgemäßen Verfahrens besonders vorteilhaft an die Anzahl der für die Auswertung zugrunde gelegten Abtastwerte angepasst werden. Mit steigender Anzahl von Abtastwerten wird das Ergebnis der Fehlerauswertung nämlich zuverlässiger, so dass der für die Bildung des Fehlersignals verwendete Auslöseschwellenwert verringert werden kann.

Eine weitere vorteilhafte Ausführungsform des erfindungsgemäßen Verfahrens sieht außerdem vor, dass die momentanen Strom- und Spannungsabtastwerte auch dazu verwendet werden, einen komplexen Impedanzwert der von dem Schutzgerät überwachten Leitung zu berechnen, und von dem Schutzgerät ein zweites einen Kurzschluss auf der Leitung angebendes Fehlersignal erzeugt wird, wenn der komplexe Impedanzwert innerhalb eines vorgegebenen Auslösegebietes in der komplexen Ebene liegt.

Auf diese Weise kann quasi parallel zu dem vorstehend beschriebenen erfindungsgemäßen Verfahren ein klassischer Distanzschutzalgorithmus, der auf der Berechnung von komplexen Fehlerimpedanzen beruht, ausgeführt werden. Hierdurch kann eine Entscheidung über das Vorliegen eines Kurzschlusses noch zuverlässiger getroffen werden.

In diesem Zusammenhang ist gemäß einer weiteren vorteilhaften Ausführungsform des erfindungsgemäßen Verfahrens schließlich vorgesehen, dass das Schutzgerät ein Auslösesignal zur Auslösung eines die Leitung begrenzenden Leistungsschalters erzeugt, sobald das erste oder das zweite Fehlersignal vorliegt.

Auf diese Weise kann ein Fehlersignal bereits dann erzeugt werden, wenn lediglich einer der beiden Distanzschutzalgorithmen einen Kurzschluss auf der Leitung erkannt hat, so dass der für den speziellen Kurzschlussfall jeweils schnellste Algorithmus eine Abschaltung der Leitung bewirken kann. Hierdurch wird die Sicherheit des Verfahrens weiter erhöht.

Hinsichtlich des Schutzgeräts wird die oben genannte Aufgabe durch ein Schutzgerät zur Überwachung einer Leitung eines mehrphasigen elektrischen Energieversorgungsnetzes mit geerdetem Standpunkt hinsichtlich auf der Leitung auftretenden Kurzschlüssen gelöst, bei dem das Schutzgerät zur Durchführung eines Verfahrens gemäß einem der Ansprüche 1 bis 11 eingerichtet ist.

Die Erfindung soll im Folgenden anhand von Ausführungsbeispielen näher erläutert werden. Hierzu zeigen

Figur 1    eine schematische Ansicht einer überwachten Leitung eines mehrphasigen elektrischen Energieversorgungsnetzes;

Figur 2    drei elektrische Ersatzschaltbilder der überwachten Leitung zur Erläuterung des Superpositionsprinzips;

Figur 3    drei Diagramme mit Spannungsverläufen zur Erläuterung des Superpositionsprinzips;

Figur 4    ein Diagramm mit einem Spannungsverlauf zur Erläuterung der numerischen Ermittlung von Delta-Größen;

Figur 5    zwei Ersatzschaltbilder der überwachten Leitung zur Erläuterung de Funktion eines schnellen Distanzschutzalgorithmus;

Figur 6    ein Diagramm mit einem Spannungsverlauf bei einem Kurzschluss auf der überwachten Leitung;

Figur 7    ein Diagramm zur Erläuterung der dynamischen Anpassung eines Auslöseschwellenwertes;

Figur 8    drei Diagramme mit Stromverläufen bei einem Kurzschluss auf der überwachten Leitung zur Erläuterung eines Sprungdetektors; und

Figur 9    ein schematisches Blockschaltbild zur Erläuterung der Funktionsweise einer Schleifenauswahl.

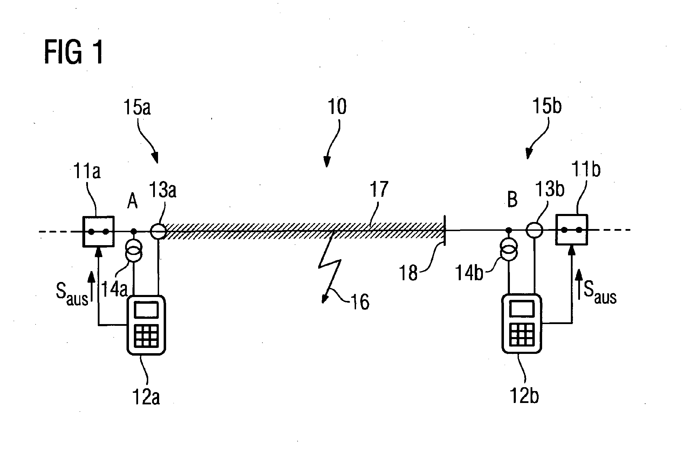

Figur 1 zeigt eine Leitung 10 eines ansonsten nicht näher dargestellten mehrphasigen elektrischen Energieversorgungsnetzes. Die Leitung 10 wird an ihren beiden Enden A und B von Leistungsschaltern 11a und 11b begrenzt, über die im Fehlerfall eine Abschaltung der betroffenen Phasenleiter der Leitung 10 vorgenommen werden kann. Zu diesem Zweck sind an den Leitungsenden A und B an Messstellen 15a und 15b elektrische Schutzgeräte 12a und 12b vorgesehen. Diesen werden an den jeweiligen Messstellen 15a, 15b mittels lediglich schematisch dargestellten Stromwandlern 13a, 13b und Spannungswandlern 14a, 14b aufgenommene Strom- und Spannungssignale zugeführt.

Die Schutzgeräte 12a, 12b führen mittels einer A/D-Wandlung eine Abtastung der Strom- und Spannungssignale durch und führen für die so erzeugten Strom- und Spannungsabtastwerte eine Fehlerauswertung durch, um eventuelle Kurzschlüsse 16 auf der Leitung 10 erkennen zu können. Bei einem solchen Kurzschluss 16 kann es sich entweder um einen einpoligen Kurzschluss zwischen einem Phasenleiter und Erde oder um einen zwei- oder mehrpoligen Kurzschluss mit Beteiligung mehrerer Phasenleiter handeln. Ergibt die Fehlerauswertung einen Kurzschluss 16 auf der Leitung, so wird ein Auslösesignal $S_{aus}$ erzeugt und dem jeweiligen Leistungsschalter 11a, 11b zugeführt, um diesen zum Öffnen seiner Schaltkontakte zu veranlassen und so den/die von dem Kurzschluss 16 betroffenen Phasenleiter vom übrigen Energieversorgungsnetz abzutrennen.

Eine solche Fehlerauswertung anhand lediglich an einem Ende aufgenommener Strom- und Spannungsabtastwerte kann üblicherweise nicht für die komplette Leitungslänge durchgeführt werden, da die an einer Messstelle, z. B. der Messstelle 15a an dem Leitungsende A, ermittelten Abtastwerte im Falle eines in der Nähe des jeweils anderen Leitungsendes, beispielsweise des Leitungsendes B, liegenden Kurzschlusses aufgrund der hohen Leitungsimpedanz von der Messstelle bis zur Fehlerstelle nur sehr ungenau erfasst werden können. Aus diesem Grund stellt man in den Schutzgeräten 12a, 12b üblicherweise sogenannte Überwachungs- oder Schutzzonen ein, die diejenige Leitungslänge beginnend an der jeweiligen Messstelle 15a, 15b angeben, die von dem Schutzgerät 12a bzw. 12b effektiv überwacht wird. In Figur 1 ist eine solche Überwachungszone 17 schematisch durch eine Schraffierung eines von dem Schutzgerät 12a überwachten Teils der Leitung 10 dargestellt. Die Länge einer Überwachungszone wird üblicherweise als Parameter in dem jeweiligen Schutzgerät 12a, 12b in Prozent der Leitungslänge vorgegeben; beispielsweise kann eine Überwachungszone 85% der gesamten Länge der Leitung 10 betragen. Das Ende 18 der jeweiligen Schutzzone 17 wird auch als sogenannte Kippgrenze bezeichnet.

Anhand der folgenden Figuren sollen nun Ausführungsbeispiele für ein von dem Schutzgerät 12a an dem Leitungsende A durchgeführtes Distanzschutzverfahren erläutert werden, um einen in der Überwachungszone 17 aufgetretenen Kurzschluss 16 schnell erkennen und abschalten zu können.

Das im Folgenden erläuterte schnelle Distanzschutzverfahren bedient sich zur Fehlerauswertung der Strom- und Spannungsabtastwerte sogenannten "Delta-Werten", die nach dem Superpositionsprinzips ermittelt werden, das daher im Folgenden zunächst kurz erläutert werden soll.

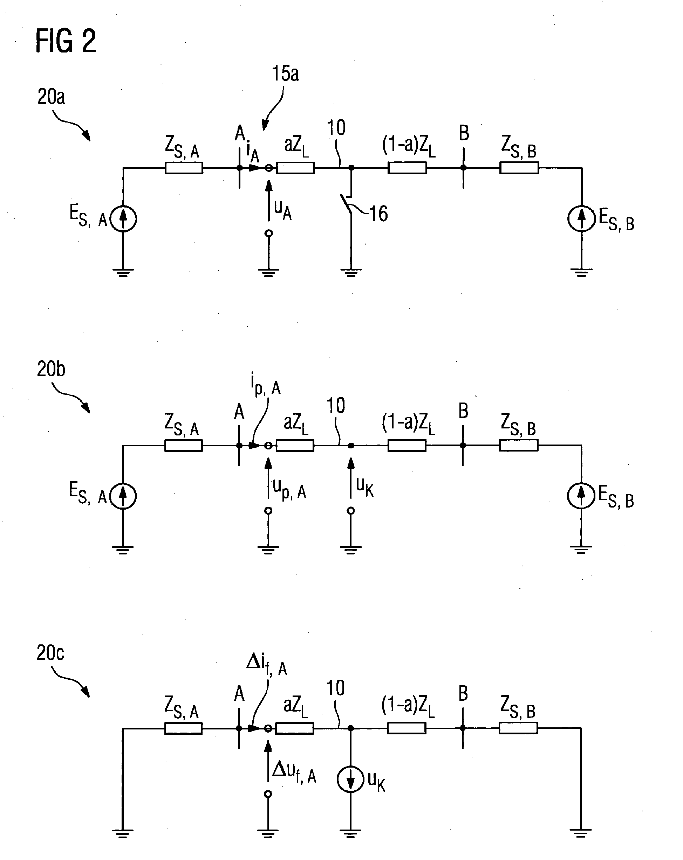

Jeder lineare elektrische Stromkreis kann gemäß dem Superpositionsprinzip in mehrere äquivalente Kreise zerlegt werden kann, wobei alle äquivalenten Kreise die gleichen passiven Topologien aufweisen müssen, die auch der ursprüngliche Kreis aufweist. Darüber hinaus muss die im elektrischen Sinne betrachtete Summe von allen aktiven Elementen (Energiequellen und -senken) der nach dem Superpositionsprinzip zerlegten Kreise den aktiven Elementen des realen Ausgangskreises entsprechen. In Figur 2 ist ein Ersatzschaltkreis 20a der von dem Kurzschluss 16 behafteten Leitung 10 aus Figur 1 gezeigt (in Figur 2 sind für den Komponenten aus Figur 1 entsprechende Komponenten gleiche Bezugszeichen gewählt worden). Die Leitung 10 wird von Spannungsquellen $E_{S,A}$ und $E_{S,B}$ mit entsprechenden Vorimpedanzen $Z_{S,A}$ und $Z_{S,B}$ von beiden Leitungsenden A, B gespeist. An der Messstelle 15a lassen sich das Stromsignal $i_A$ und das Spannungssignal $u_A$ abgreifen. Der Kurzschluss 16 wird durch Schließen eines Schalters simuliert. Die Leitungsimpedanz $Z_L$ bezieht sich auf die gesamte Länge der Leitung 10; entsprechend kann die Leitungsimpedanz von der Messstelle 15a am Leitungsende A bis zur Fehlerstelle mit $a \cdot Z_L$ angegeben werden (a ist die auf die gesamte Leitungslänge bezogene Entfernung vom Leitungsende A zur Fehlerstelle).

Der Ersatzschaltkreis 20a in Figur 2 lässt sich nach dem Superpositionsprinzip in einen Ersatzschaltkreis 20b, der den Betriebszustand der Leitung 10 vor Eintritt des Kurzschlusses 16 wiedergibt, und einen Ersatzschaltkreis 20c, der die durch den Eintritt des Kurzschlusses 16 hervorgerufenen Änderungen des Zustands der Leitung 10 angibt, zerlegen.

Der Ersatzschaltkreis 20b umfasst die Spannungsquellen $E_{S,A}$ und $E_{S,B}$. An der Stelle, an der im Ersatzschaltkreis 20a der Kurzschluss 16 auftritt, liegt die Spannung $u_k$ an. An der Messstelle 15a liegen die Vorfehlerspannung $u_{p,A}$ und der Vorfehlerstrom $i_{p,A}$ vor.

Der weitere Ersatzschaltkreis 20c stellt die Situation nach der Änderung der Netztopologie dar. Die aus diesem Kreis gewonnenen Strom- und Spannungsgrößen nennt man Delta-Größen $\Delta i_{f,A}$ und $\Delta u_{f,A}$, da sie sich auf die durch den Kurzschluss hervorgerufenen Änderungen von Strom- und Spannung beziehen. Diese Delta-Größen werden durch die den Kurzschluss 16 repräsentierende fiktive Spannungsquelle -$u_k$ an der Fehlerstelle getrieben.

Bei Überlagerung (Superposition) der Ersatzschaltkreise 20b (Situation vor dem Kurzschluss) und 20c (Änderungen durch den Kurzschluss) ergibt sich folglich der Ersatzschaltkreis 20a.

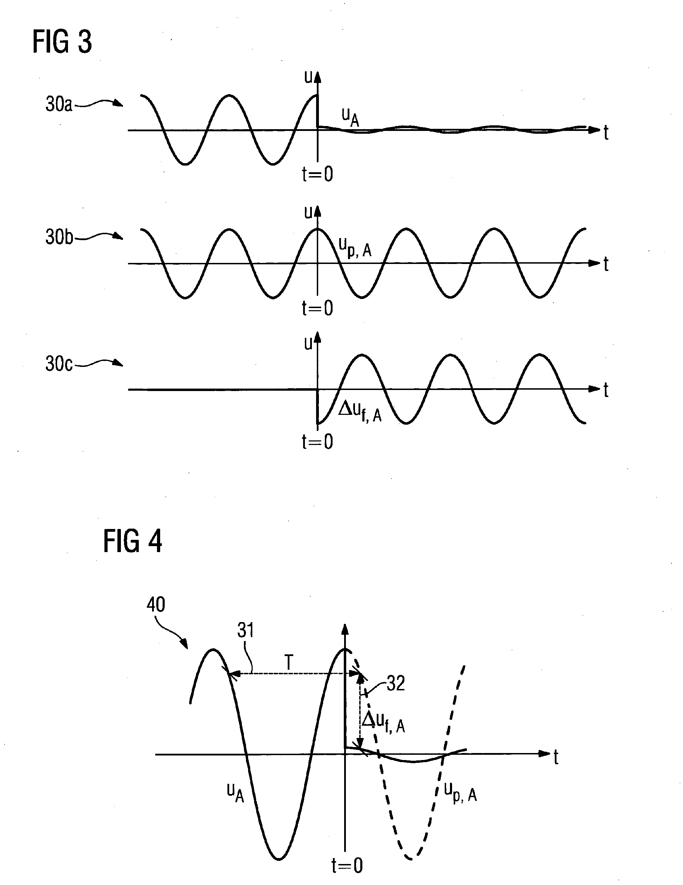

Da in Wirklichkeit aufgrund der fehlenden Information über die Distanz a zur Fehlerstelle die Netztopologie und ihre Komponenten unbekannt sind, lassen sich die Delta-Größen von Strömen und Spannungen nicht aus der Berechnung des Netzkreises bestimmen. Sie können aber durch Differenzbildung der Vorfehlergrößen $i_{p,A}$ und $u_{p,A}$ mit den Fehlergrößen $i_A$, $u_A$ bestimmt werden. Hierbei wird angenommen, dass die Vorfehlergrößen ein stabiles Verhalten des Netzes widerspiegeln. Figur 3 zeigt den Zusammenhang zwischen Fehlergrößen $i_A$, $u_A$, Vorfehlergrößen $i_{p,A}$, $u_{p,A}$ und Delta-Größen $\Delta i_{f,A}$, $\Delta u_{f,A}$ nochmals in Form dreier Diagramme 30a, 30b und 30c. Das Diagramm 30a zeigt hierbei den zeitlichen Verlauf der real an der Messstelle 15a vor und nach Eintritt des Kurzschlusses bei t=0 gemessenen Spannung $u_A$. Das Diagramm 30b stellt die Situation so dar, als sei kein Fehler eingetreten, bezieht sich also lediglich auf den Verlauf der Vorfehlergrößen $u_{p,A}$, während sich der in Diagramm 30c gezeigte Verlauf der Delta-Spannung $\Delta u_{f,A}$ ausschließlich auf die durch den Kurzschluss erzeugten Änderungen bezieht. Bei Addition der Verläufe der Vorfehlergrößen $u_{p,A}$ und Deltagrößen $\Delta u_{f,A}$ ergibt sich wiederum der Verlauf der real an der Messstelle 15a erfassten Spannung $u_A$, daher lassen sich die jeweiligen Delta-Größen durch Differenzbildung der Verläufe für die Spannung $u_A$ und die Vorfehlerspannung $u_{p,A}$ berechnen.

Die Vorgehensweise bei der praktischen Berechnung der DeltaGrößen für Strom und Spannung ist in Figur 4 näher dargestellt. Figur 4 zeigt ein Diagramm 40, in das in durchgezogener Linie der Verlauf der tatsächlich an der Messstelle 15a erfassten Spannung $u_A$ eingezeichnet ist. Man erkennt, dass die Spannung $u_A$ mit Beginn des Kurzschlusses bei t=0 sprunghaft absinkt und danach mit entsprechend niedrigerer Amplitude verläuft. In gestrichelter Linie ist nach Fehlereintritt bei t=0 der - fiktive - Verlauf der Vorfehler-Spannung $u_{p,A}$ eingetragen, der sich ergeben würde, wenn kein Kurzschluss bei t=0 eingetreten wäre. Der Wert der jeweiligen Vorfehler-Spannung $u_{p,A}$ lässt sich durch zeitliche Verschiebung entlang der Zeitachse um eine volle Schwingungsperiode T (oder ein Vielfaches einer vollen Schwingungsperiode) ermitteln, wie durch einen Pfeil 31 in Figur 3 angedeutet wird. Folglich gilt für die Vorfehler-Spannung die Beziehung:

$$u_{p,A}(t) = u_A(t-T) \; .$$

Praktisch müssen in dem die Fehlerauswertung durchführenden Schutzgerät 12a (siehe Figur 1) folglich die erfassten Abtastwerte für die Dauer mindestens einer vollen Schwingungsperiode gespeichert werden, um den Verlauf der fiktiven Vorfehlergrößen $u_{p,A}$ berechnen zu können. Wie Figur 3 ferner entnommen werden kann, lässt sich der Verlauf der Delta-Spannung $\Delta u_{f,A}$ - wie durch einen weiteren Pfeil 32 angedeutet - durch Differenzbildung gemäß

$$\Delta u_{f,A}(t) = u_{p,A}(t) - u_A(t)$$

bestimmen.

Zwischen den Vorfehlergrößen und den Delta-Größen tritt noch eine mathematische Verbindung auf, nämlich die Spannung $u_k$ an der Fehlerstelle, die sich aus den beiden Größen bestimmen lässt. Diese fiktive Spannungsquelle ist der Entscheidungsfaktor zur Distanzbestimmung des Fehlers:

$$u_k = u_A - a Z_L \cdot i_A$$

und

$$u_k = \Delta u_{f,A} - aZ_L \cdot \Delta i_{f,a}$$

wobei wie oben erläutert $u_A$ und $i_A$ messbare und $\Delta u_{f,A}$ und $\Delta_{f,A}$ berechnete Größen sind.

Eine unbekannte Größe ist jedoch die Impedanz $aZ_L$ bis zur Fehlerstelle, die den Kurzschlusspunkt des Netzes widerspiegelt. Um zu entscheiden, ob der Kurzschluss in dem zu schützenden Bereich (Überwachungszone 17, siehe Figur 1) liegt, muss ein Einstellwert $Z_{ref}$ für eine Referenzstelle 18, die vorteilhaft am Ende der Überwachungszone 17 liegt, eingeführt werden, der somit die entsprechende Überwachungszone bestimmt. Dieser Einstellwert $Z_{ref}$ lässt sich in die Berechnung so integrieren, dass eine Bestimmung der Fehlerposition derart möglich ist, dass in der Überwachungszone liegende Fehler von solchen außerhalb der Überwachungszone unterschieden werden können. Mittels des Einstellwertes $Z_{ref}$ lässt sich zum einen hinsichtlich der Vorfehlerspannungen eine fiktive Referenzspannung am Ende der eingestellten Überwachungszone vor dem Fehlereintritt berechnen. Zum anderen lässt sich unter Verwendung des Einstellwertes $Z_{ref}$ und der Delta-Spannungen auch eine fiktive Vergleichsspannung an der Fehlerstelle bestimmen, die vorliegen würde, wenn der Fehler am Ende der Überwachungszone eingetreten wäre. Aus der Analyse der beiden berechneten Spannungen lassen sich folgende Rückschlüsse ziehen:

- Liegt der Kurzschluss am Ende der Überwachungszone ($aZ_L = Z_{ref}$), stimmen die Werte der Referenzspannung und der Vergleichsspannung (nahezu) überein.
- Liegt der Kurzschluss in der Überwachungszone ($aZ_L < Z_{ref}$), wird die aus den Delta-Spannungen berechnete Vergleichsspannung größer als die Referenzspannung.
- Liegt der Fehler außerhalb der Zone ($aZ_L > Z_{ref}$ oder $aZ_L < 0$), wird die Referenzspannung größer als die sich aus den Delta-Spannungen ergebene Vergleichsspannung.

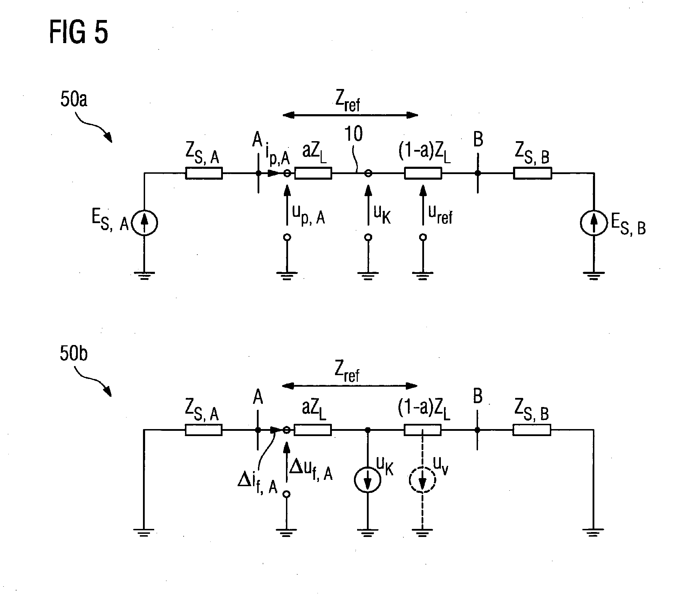

Somit können die Delta-Größen für die Distanzmessung behilflich sein. Um bei der auf den Delta-Größen basierenden Methode keinen Zeitverzug aufgrund der Verwendung von Zeitfenstern zur Berechnung komplexer Größen zu haben, wird sie in der zeitlichen Form mit Momentanwerten implementiert. Hierbei ist die Umwandlung von Vorfehler- und Delta-Größen in die komplexe Form nicht notwendig. Dadurch kann die Entscheidung des Schutzgeräts über das Vorliegen eines Kurzschlusses beschleunigt werden, weil man nicht warten muss, bis ein Messfenster mit Messwerten gefüllt ist und die komplexen Größen berechnet werden können. Analog zur bisher beschriebenen Vorgehensweise werden zuerst die momentanen Referenzspannungswerte und die momentanen Vergleichsspannungswerte ermittelt. Diese Ermittlung soll anhand der in Figur 5 gezeigten Ersatzschaltkreise 50a und 50b erläutert werden.

Die Berechnung der Referenzspannung $u_{ref}$ kann anhand des Ersatzschaltkreises 50a in Figur 5 erläutert werden. Dieser Ersatzschaltkreis spiegelt die Vorfehlergrößen wider. Die Referenzspannung $u_{ref}$ wird mittels der folgenden auf die Abtastwerte n bezogenen Gleichung bestimmt:

$$u_{ref}(n) = u_p(n) - L_{ref}\frac{i_p(n) - i_p(n-1)}{T} - R_{ref} \cdot i_p(n) \, ,$$

wobei die Impedanz $Z_{ref}$ durch die äquivalente Induktivität $L_{ref}$ und die Resistanz $R_{ref}$ ersetzt wurde. Ferner bedeuten $u_p(n) = u(n-N)$ einen Vorfehler-Spannungsabtastwert, der eine Periodendauer T vor dem momentanen Spannungsabtastwert $u(n)$ aufgetreten ist, und $i_p(n) = i(n-N)$ einen Vorfehler-Stromabtastwert, der eine Periodendauer T vor dem momentanen Stromabtastwert $u(n)$ aufgetreten ist. Die Anzahl von Abtastwerten pro Periodendauer ist N. Der Index n steht für die Nummer des Abtastwertes nach Fehlereintritt.

Zur Fehlerauswertung muss zudem eine sich aus den Delta-Größen (also der durch den Kurzschluss hervorgerufenen Änderungen) von Strom und Spannung ergebene Vergleichsspannung $u_v$ am Ende der durch Impedanz $Z_{ref}$ eingestellten Überwachungszone bestimmt werden. Diese Vergleichsspannung $u_v$ lässt sich mittels des Ersatzschaltkreises 50b aus Figur 5 berechnen. Dabei müssen zuerst die Delta-Größen als Differenz aus den momentanen Abtastwerten und den entsprechenden Vorfehler-Abtastwerten, also den gespeicherten Abtastwerten, die eine Schwingungsperiode (oder ein Vielfaches davon) vor den aktuellen Abtastwerten erfasst worden sind. Mit diesen Delta-Größen $\Delta u_f$ und $Ai_f$ ergibt sich die Vergleichsspannung bezogen auf die Abtastwerte n zu:

$$u_V(n) = \Delta u_f(n) - L_{ref}\frac{\Delta i_f(n) - \Delta i_f(n-1)}{T} - R_{ref}\cdot\Delta i_f(n)\ .$$

Die dargestellten Gleichungen für $u_{ref}$ und uv erlauben zunächst nur eine Berechnung von Momentanwerten, die zur Fehlerauswertung zu ungenau sind, da sie von Messfehlern, Ausreißern oder zufälligen Schwankungen behaftet sein könnten. Momentanwerte sind daher keine zuverlässige Basis zur Fehlerauswertung. Aus diesem Grund wird vorgeschlagen, die Bewertung aufgrund von gleichgerichteten Werten der Referenzspannung $u_{ref}$ und der Vergleichsspannung $u_V$ durchzuführen. Die gleichgerichtete Referenzspannung $U_{ref}$ wird wie folgt ermittelt:

$$U_{ref}(n) = \frac{2}{N}\sum_{k=n-(\frac{N}{2}-1)}^{n}\left(\left|u_{ref}(k)\right|\right),$$

mit

$U_{ref}(n)$ : gleichgerichteter Referenzspannungswert;
$u_{ref}(k)$ : momentaner Referenzspannungswert für den Abtastwert k;
n : Nummer des Abtastwertes nach Fehlereintritt;
N : Anzahl der Abtastwerte pro Periodendauer;
k : Aufsummierungsindex.

Um die Berechnung zu verkürzen und dabei die Geschwindigkeit des Verfahrens zu erhöhen, kann die gleichgerichtete Referenzspannung während einer halben Netzperiode bestimmt werden. Da die gleichgerichtete Referenzspannung vor dem Fehlereintritt konstant bleibt, ist ihre messtechnische Erfassung unproblematisch.

Die gleichgerichtete Vergleichsspannung $U_V$ wird entsprechend gemäß der folgenden Gleichung bestimmt:

$$U_V(n) = \frac{2}{N}\sum_{k=n-(\frac{N}{2}-1)}^{n}\left(\left|u_V(k)\right|\right)$$

mit

$U_V(n)$ : gleichgerichteter Vergleichsspannungswert;
$u_V(k)$ : momentaner Vergleichsspannungswert für den Abtastwert k;
n : Nummer des Abtastwertes nach Fehlereintritt;
N : Anzahl der Abtastwerte pro Periodendauer;
k : Aufsummierungsindex.

Das bedeutet, dass das Verfahren bei einer Abtastfrequenz 1kHz maximal 10 Abtastwerte benötigt, um die gleichgerichtete Vergleichsspannung $U_V$ bestimmen zu können. Die Entscheidung bezüglich eines auf der Leitung liegenden Kurzschlusses kann folglich nach maximal 10 Abtastwerten getroffen werden, wodurch eine deutliche Geschwindigkeitssteigerung erreicht wird.

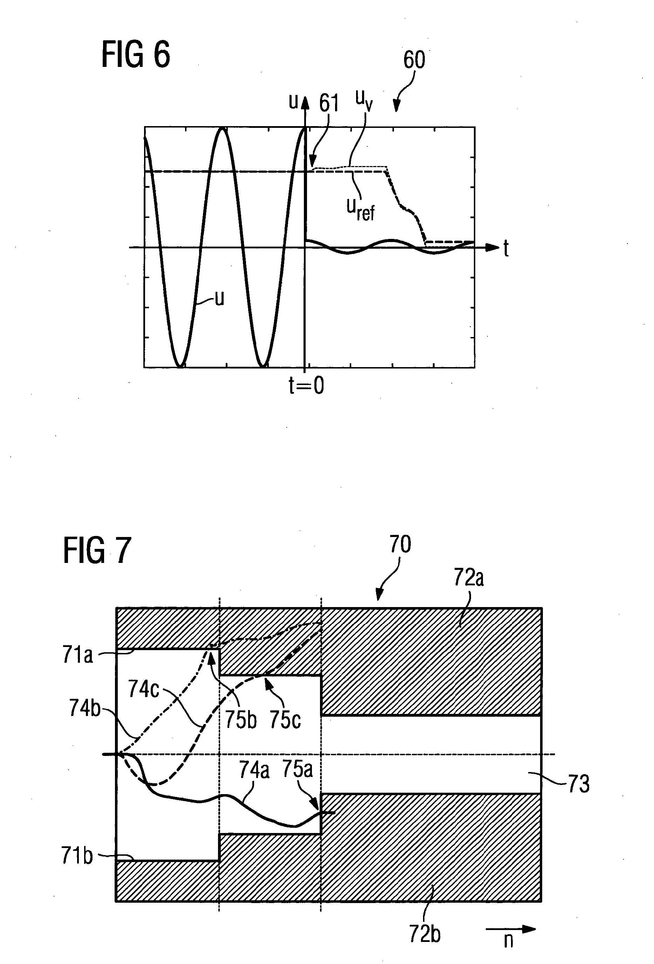

In Figur 6 ist das Ergebnis der Fehlerauswertung für einen einpoligen Kurzschluss innerhalb der Überwachungszone dargestellt. In Figur 6 sind in einem Diagramm 60 die zeitlichen Verläufe der tatsächlich an der Messstelle 15a (vgl. Figur 1) gemessenen Spannung u, der gleichgerichteten Referenzspannung $U_{ref}$ und der gleichgerichteten Vergleichsspannung $U_V$ dargestellt. Bis zum Eintritt des Kurzschlusses bei t=0 stimmen die Werte für die gleichgerichtete Referenzspannung $U_{ref}$ und die gleichgerichtete Vergleichsspannung $U_V$ überein, d.h. die Differenz aus beiden liegt unterhalb eines Auslöseschwellenwertes. Hingegen erkennt man bereits kurz nach Eintritt des Kurzschlusses an der Stelle 61 eine Erhöhung der gleichgerichteten Vergleichsspannung $U_V$, während die gleichgerichtete Referenzspannung $U_{ref}$, da sie anhand der Vorfehlergrößen gebildet wird, weiter konstant bleibt. Somit übersteigt an der Stelle 61 die Differenz aus der gleichgerichteten Referenzspannung und der gleichgerichteten Vergleichsspannung erstmalig den Auslöseschwellenwert und es wird ein entsprechendes Fehlersignal zum Abschalten de Leitung erzeugt.

Anhand des Verlaufs der gleichgerichteten Vergleichsspannung $U_v$ in Figur 6 lässt sich erkennen, dass immer eine gewisse Anzahl n von Abtastwerten benötigt wird, um bei Kurzschlüssen innerhalb der Überwachungszone den Auslöseschwellenwert zu überschreiten. Dennoch kann bei dem Beispiel gemäß Figur 6 eine Entscheidung innerhalb einer Zeitdauer unter eine halben Periodendauer getroffen werden.

Zusammengefasst kann festgestellt werden, dass das vorgestellte Verfahren zur Erkennung eines Kurzschlusses auf einer Leitung eines elektrischen Energieversorgungsnetzes vorteilhaft eine Fehlerauswertung anhand von gleichgerichteten Werten der momentanen Referenzspannung $u_{ref}$ und der Vergleichsspannung $u_v$ nutzt. Die Verwendung gleichgerichteter Werte hat gegenüber den Momentanwerten den Vorteil, dass eine wesentlich zuverlässigere Entscheidung hinsichtlich eines Kurzschlusses innerhalb der Überwachungszone möglich ist, da Ausreißer von einzelnen Abtastwerten nicht sofort zu einer möglichen Fehlauslösung führen. Zudem können kurzzeitige Messfehler nach dem Eintritt eines externen, also außerhalb der Überwachungszone liegenden, Kurzschlusses nicht unmittelbar zu einer Fehlauslösung führen und haben damit einen geringeren Einfluss auf das Verhalten der Fehlerauswertung. Außerdem kann sichergestellt werden, dass auch bei ungenauer Vorgabe der Leitungsparameter die Genauigkeit der Fehlerauswertung nicht so stark beeinflusst wird.

Für die Stabilisierung der Entscheidung der Fehlerauswertung kann zusätzlich die in Figur 7 dargestellte Charakteristik des Auslöseschwellenwertes eingesetzt werden. Hierzu zeigt Figur 7 eine sogenannte Auslösecharakteristik 70, die den Verlauf des Auslöseschwellenwertes (der in der Auslösecharakteristik 70 durch positiven Anteil 71a und einen negativen Anteil 71b angegeben ist) mit zunehmender Anzahl n von zur Berechnung der gleichgerichteten Vergleichsspannung $U_v$ verwendeten Abtastwerte von Strom und Spannung angibt. Der schraffierte Bereich 72a oberhalb des positiven Anteils 71a des Auslöseschwellenwertes gibt den Bereich für die Differenz aus der gleichgerichteten Referenzspannung $U_{ref}$ und der gleichgerichteten Vergleichsspannung $U_v$ an, innerhalb dessen auf einen internen Kurzschluss innerhalb der Überwachungszone geschlossen wird, während der Bereich 72b unterhalb des negativen Anteils 71b des Auslöseschwellenwertes auf einen außerhalb der Überwachungszone liegenden externen Kurzschluss hindeutet. Innerhalb des zwischen diesen beiden Bereichen 72a und 72b liegenden Zwischenbereichs kann hingegen keine eindeutige Aussage getroffen werden. Man erkennt, dass mit steigender Anzahl n von für die Fehlerauswertung verwendeten Abtastwerten von Strom und Spannung der Zwischenbereich 73, innerhalb dessen keine Entscheidung möglich ist, in Stufenschritten abnimmt, da mit steigender Anzahl von Abtastwerten der Wert der gleichgerichteten Vergleichsspannung $U_v$ immer zuverlässiger bestimmt werden kann und damit die Zuverlässigkeit der gesamten Fehlerauswertung steigt.

In Figur 7 sind drei Verläufe 74a - 74c der Differenz aus der gleichgerichteten Vergleichsspannung $U_v$ und der gleichgerichteten Referenzspannung $U_{ref}$ beispielhaft dargestellt. Der Verlauf 74a nimmt früh negative Werte an und führt schließlich zur Erkennung eines externen Fehlers an der Stelle 75a. Der Verlauf 74b nimmt gleich nach Fehlereintritt positive Werte an und führt bereits früh an der Stelle 75b zur Erkennung eines internen Kurzschlusses auf der überwachten Leitung. Der Verlauf 74c hingegen nimmt zunächst negative Werte an, wird danach doch positiv und führt schließlich an Stelle 75c zu einer Erkennung eines internen Kurzschlusses auf der überwachten Leitung.

Neben der Anzahl der für die Fehlerauswertung herangezogenen Abtastwerte können auch weitere Faktoren den Verlauf des Auslöseschwellenwertes bestimmen (in Figur 7 nicht dargestellt). Beispielsweise kann der Bereich 73, innerhalb dessen keine Entscheidung getroffen werden kann, umso größer ausfallen, je mehr Störungen in Form von z.B. Oberschwingungen oder Frequenzabweichungen hinsichtlich der erfassten Ströme und Spannungen vorliegen.

Das beschriebene Verfahren kann durch der Fehlerauswertung vorgelagerte Maßnahmen Ressourcen schonender durchgeführt werden, so dass der Anteil an Rechenkapazität, die eine Datenverarbeitungseinrichtung (CPU, DSP) eines Schutzgerätes zur Durchführung der Fehlerauswertung aufwenden muss verringert werden kann. Hierzu kann beispielsweise vorgesehen sein, dass zunächst lediglich anhand einfacher Kriterien eine Überprüfung durchgeführt wird, ob überhaupt ein Kurzschluss auf der Leitung vorliegt. Hierzu wird ein sogenannter Sprungdetektor eingesetzt, der die Phase-Phase-Ströme der jeweiligen Phasenleiter oder von den Phase-Phase-Strömen abgeleitete Werte (z.B. auf den Phase-Phase-Strömen basierende Delta-Größen, ggf. in gleichgerichteter Form) auf auffällige Stromsprünge untersucht und ein erstes Anregesignal angibt, wenn ein solcher Stromsprung, also eine Stromänderung, die einen Stromschwellenwert übersteigt, erkannt worden ist.

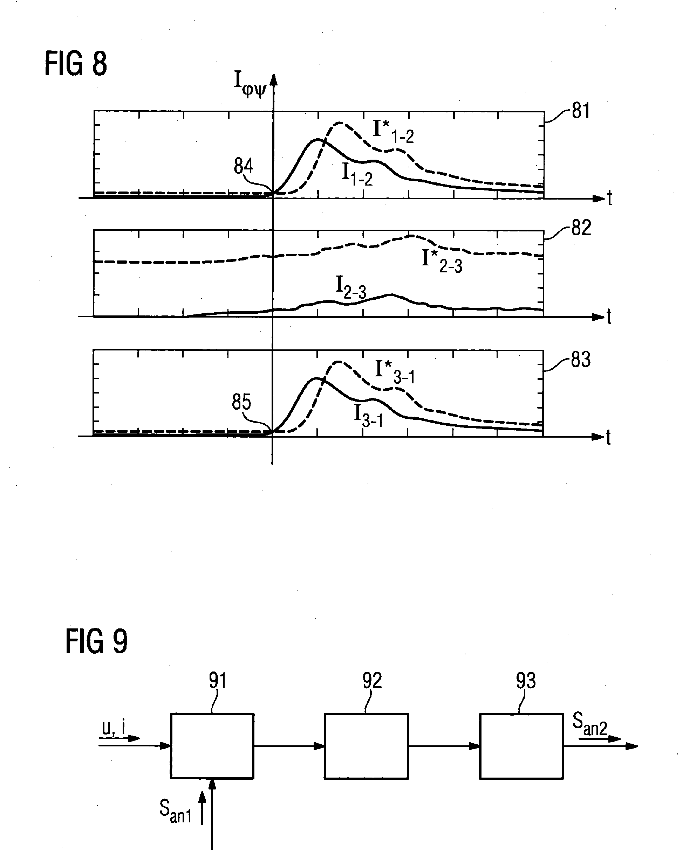

Figur 8 zeigt in diesem Zusammenhang einen von einem Sprungdetektor erfassten Stromverlauf $I_{\phi\psi}$; die Indizes $\phi$ und $\psi$ dienen hierbei als Platzhalter für die einzelnen betrachteten Phasenleiter (Phase 1, Phase 2, Phase 3) der 3-phasigen Leitung. So ist in einem ersten Diagramm 81 der Stromverlauf des Phase-Phase-Stroms $I_{1-2}$ für die Phasenleiter Phase 1 und Phase 2 in durchgezogener Linie dargestellt. Im Diagramm 82 ist in durchgezogener Linie der Phase-Phase-Strom $I_{2-3}$ für die Phasenleiter Phase 2 und Phase 3 dargestellt, während schließlich im Diagramm 83 in durchgezogener Linie der Phase-Phase-Strom $I_{3-1}$ für die Phasenleiter Phase 3 und Phase 1 aufgezeigt ist. In gestrichelter Linie sind in den einzelnen Diagrammen 81, 82, 83 jeweils zugehörige Sprungschwellenwerte $I_{1-2}^*$, $I_{2-3}^*$, $I_{3-1}^*$ gezeigt, wobei in dem Ausführungsbeispiel gemäß Fig. 8 diese Sprungschwellenwerte zur Stabilisierung der Sprungerkennung dynamisch z.B. an die Größe des fließenden Nullstromes angepasst werden.

Bei dem Ausführungsbeispiel gemäß Fig. 8 soll angenommen werden, dass die Phase 1 von einem einpoligen Kurzschlussschluss betroffen ist. Entsprechend zeigen die Stromverläufe $I_{1\text{-}2}$ im Diagramm 81 und $I_{3\text{-}1}$ im Diagramm 83 an den Stellen 84 und 85 eine Schwellenwertverletzung, während im Diagramm 82 der Stromverlauf $I_{2\text{-}3}$ deutlich unterhalb des Verlaufes des Sprungschwellenwertes $I_{2\text{-}3}^*$ bleibt. Der Sprungdetektor gibt in diesem Beispiel mit Verletzung der entsprechenden Sprungschwellenwerte an den Stellen 84 und 85 ein erstes Anregesignal ab, das beispielsweise als Triggersignal für die nachfolgende Fehlerauswertung der Strom- und Spannungsabtastwerte genutzt werden kann. Solange kein erstes Anregesignal vom Sprungdetektor erzeugt wird, findet dementsprechend auch keine Auswertung der Strom- und Spannungsabtastwerte hinsichtlich eines Kurzschlusses auf der Leitung statt, so dass durch Vorschaltung des Sprungdetektors erhebliche Rechenressourcen der CPU des Schutzgeräts eingespart werden können.

Eine weitere Möglichkeit, um Rechenleistung bei der Fehlerauswertung einzusparen, besteht darin, bei Vorliegen des ersten Anregesignals eine Schleifenerkennung durchzuführen, mit der die jeweilige von dem Kurzschluss betroffene Schleife (z.B. Phase 1 - Erde oder Phase 2 - Phase 3) erkannt werden kann und die Auswertung der Strom- und Spannungsabtastwerte danach ausschließlich für die erkannte Fehlerschleife durchgeführt wird. Dies soll anhand von Fig. 9 näher erläutert werden.

Figur 9 zeigt hierzu ein Blockschaltbild der Funktionsweise einer Schleifenerkennungsfunktion. Ein von dem Sprungdetektor erzeugtes erstes Anregesignal $S_{an1}$ wird einem ersten Verarbeitungsblock 91 zugeführt. Das erste Anregesignal $S_{an1}$ dient damit quasi als Trigger zum Start der Schleifenerkennung und bewirkt, dass an dem ersten Verarbeitungsblock 91 zusätzlich anliegende Abtastwerte u und i eingelesen werden. In dem ersten Verarbeitungsblock 91 werden daraufhin gleichgerichtete Delta-Größen der Ströme und Spannungen berechnet und einem zweiten Verarbeitungsblock 92 zugeführt. Der zweite Verarbeitungsblock 92 führt diverse Schwellenwertvergleiche hinsichtlich der aus den Stromabtastwerten gewonnenen Delta-Größen durch.

Das Ergebnis dieser Abrufung wird an einen dritten Verarbeitungsblock 93 weitergegeben, der anhand weiterer Abprüfungen hinsichtlich von aus den Strom- und/oder Spannungsabtastwerten gewonnen Delta-Größen die in dem zweiten Verarbeitungsblock 92 gewonnenen Ergebnisse überprüft. Können bei der Prüfung in dem dritten Verarbeitungsblock 93 die Ergebnisse aus dem zweiten Verarbeitungsblock 92 bestätigt werden, so gibt der dritte Verarbeitungsblock 93 ein zweites Anregesignal $S_{an2}$ ab, das die von dem Kurzschluss behaftete Fehlerschleife angibt.

Zur Überprüfung auf einen einpoligen Phase-Erde-Kurzschluss kann in dem zweiten Verarbeitungsblock 92 beispielsweise die folgende Bedingung abgeprüft werden (die Indizes $\varphi$, $\psi$ und $\gamma$ dienen hierbei als Platzhalter für die Bezeichnung der drei Phasen der Leitung):

$$\Delta I_{\psi\varphi} > k_{ipp} \cdot \Delta I_{\varphi\gamma} \quad \text{UND} \quad \Delta I_{\psi\gamma} > k_{ipp} \cdot \Delta I_{\varphi\gamma} \quad \text{UND} \quad \Delta I_{30} > kI_N \ .$$

$I_{30}$ steht hierbei für die Nullsystemspannung, k mit verschiedenen Indizes steht für vorgegebene Vergleichs-Parameter. Ist die vorgenannte Bedingung erfüllt, so wird an den dritten Verarbeitungsblock 93 ein entsprechendes Zwischensignal abgegeben. Der dritte Verarbeitungsblock 93 führt daraufhin eine Überprüfung des Ergebnisses des zweiten Verarbeitungsblocks 92 durch, indem beispielsweise folgende Bedingung abgeprüft wird:

$$\Delta U_{\psi} > k_{upp} \cdot \Delta U_{\varphi\gamma} \quad \text{ODER} \quad ( \ \Delta I_{\psi} > k_{ip} \cdot \Delta I_{\gamma} \quad \text{UND} \quad \Delta I_{\psi} > k_{ip} \cdot \Delta I_{\varphi} \ ) \ .$$

Ist diese Bedingung erfüllt, so bestätigt der dritte Verarbeitungsblock 93 die Ergebnisse des zweiten Verarbeitungsblocks 92 und gibt ein zweites Anregesignal $S_{an2}$ ab, dass die Schleife "Phase $\psi$ - Erde" als von dem Kurzschluss behaftet angibt.

Bei der Schleifenauswahl kann im Block 92 auch folgende Bedingung überprüft werden:

$$\Delta I_{\psi\varphi} > k_{ipp} \cdot \Delta I_{\psi\gamma} \quad \text{UND} \quad \Delta I_{\psi\varphi} > k_{ipp} \cdot \Delta I_{\varphi\gamma}$$

Ist diese Bedingung erfüllt, so gibt der Verarbeitungsblock 92 ein entsprechendes Zwischensignal an den Verarbeitungsblock 93 ab. Dieser führt eine Überprüfung anhand der folgenden Bedingung durch:

$$\Delta U_{\psi\varphi} > k_{up} \cdot \Delta U_{\gamma}$$

Ist dies erfüllt, so wird von dem dritten Verarbeitungsblock 93 ein zweites Anregesignal $S_{an2}$ abgegeben, das die Schleife "Phase $\psi$ - Phase $\varphi$" von dem Fehler behaftet ausgibt.

In dem dritten Verarbeitungsblock 93 wird ferner die folgende Bedingung abgeprüft:

$$\Delta U_{\psi} > k_{up} \cdot \Delta U_{\varphi} \, .$$

Ist diese Bedingung erfüllt, so wird ein zweites Anregesignal $S_{an2}$ ausgegeben, das die Schleife "Phase $\psi$ - Erde" als von dem Fehler betroffen angibt.

Zudem führt der dritte Verarbeitungsblock 93 die folgende Prüfung durch:

$$\Delta U_{\varphi} > k_{up} \cdot \Delta U_{\psi} \, .$$

Ist diese Bedingung erfüllt, so wird ein zweites Anregesignal $S_{an2}$ ausgegeben, das die Schleife "Phase $\varphi$ - Erde" als von dem Fehler betroffen angibt.

Durch die bei der Phasenauswahl durchgeführten Überprüfungen kann sehr zuverlässig die tatsächlich von dem Fehler behaftete Schleife angegeben werden, so dass die Auswertung der Strom- und Spannungsabtastwerte lediglich bezüglich der von der Schleifenauswahl angegebenen fehlerbehafteten Schleife durchgeführt werden muss.

Schließlich kann vorgesehen sein, dass parallel zu der beschriebenen Fehlerauswertung auch ein "klassisches" Distanzschutzverfahren durchgeführt wird, das anhand komplexer Strom- und Spannungswerte die Kurzschlussimpedanzen bestimmt und diese mit vorgegebenen Auslösegebieten vergleicht. Derjenige Algorithmus, der zuerst einen internen Kurzschluss in der Überwachungszone der Leitung erkannt hat, gibt ein entsprechendes Fehlersignal ab, das von dem betreffenden Schutzgerät in ein Auslösesignal zur Auslösung des entsprechenden Leistungsschalters umgesetzt wird. Auf diese Weise kann sichergestellt werden, dass eindeutige Kurzschlüsse, bei denen sich die gleichgerichtete Referenzspannung und die gleichgerichtete Vergleichsspannung stark voneinander unterscheiden, mit der hier vorgestellten Fehlerauswertung zu einer schnellen Auslösung führen, während bei weniger eindeutigen Kurzschlüssen, beispielsweise in unmittelbarer Nähe der Kippgrenze, auf die Zuverlässigkeit des mithin langsameren klassischen Distanzschutzverfahrens zurückgegriffen werden kann.

**Patentansprüche**

1. Verfahren zum Erkennen eines Kurzschlusses (16) auf einer Leitung (10) eines mehrphasigen elektrischen Energieversorgungsnetzes mit geerdetem Sternpunkt, bei dem folgende Schritte durchgeführt werden:

   - Aufnehmen von Strom- und Spannungsabtastwerten an einer Messstelle (15a) an einem Ende (A) der überwachten Leitung (10) durch ein elektrisches Schutzgerät (12a); und
   - Erzeugen eines einen Kurzschluss (16) auf der Leitung (10) angebenden ersten Fehlersignals, wenn eine von dem elektrischen Schutzgerät (12a) durchgeführte Fehlerauswertung der Strom- und Spannungsabtastwerte auf einen auf der Leitung (10) vorhandenen Kurzschluss (16) hinweist;
   **dadurch gekennzeichnet, dass**
   - zur Fehlerauswertung der Strom- und Spannungsabtastwerte folgende Schritte durchgeführt werden:

     - Berechnen von momentanen Referenzspannungswerten für eine Referenzstelle (18) auf der Leitung (10) aus vor Eintritt des Kurzschlusses (16) aufgenommenen momentanen Strom- und Spannungsabtastwerten;
     - Berechnen von momentanen Vergleichsspannungswerten für die Referenzstelle (18) auf der Leitung (10) aus vor Eintritt des Kurzschlusses (16) aufgenommenen momentanen Strom- und Spannungsabtastwerten und während des Kurzschlusses (16) aufgenommenen momentanen Strom- und Spannungsabtastwerten;

- Berechnen eines gleichgerichteten Referenzspannungswertes aus aufeinander folgenden momentanen Referenzspannungswerten und eines gleichgerichteten Vergleichsspannungswertes aus aufeinander folgenden momentanen Vergleichsspannungswerten;
- Vergleichen des gleichgerichteten Referenzspannungswertes und des gleichgerichteten Vergleichsspannungswertes; und
- Erzeugen des ersten Fehlersignals, wenn die Differenz aus dem gleichgerichteten Vergleichsspannungswert und dem gleichgerichteten Referenzspannungswert einen Auslöseschwellenwert übersteigt, wobei

- die Berechnung der momentanen Referenzspannungswerte gemäß folgender Gleichung erfolgt:

$$u_{ref}(n) = u_p(n) - L_{ref}\frac{i_p(n) - i_p(n-1)}{T} - R_{ref} \cdot i_p(n) \,,$$

mit

$u_{ref}(n)$ : momentaner Referenzspannungswert;
$u_p(n) = u(n-N)$ : Vorfehler-Spannungsabtastwert eine Periodendauer vor dem momentanen Spannungsabtastwert u (n) ;
$i_p(n) = i(n-N)$ : Vorfehler-Stromabtastwert eine Periodendauer vor dem momentanen Stromabtastwert i(n);
T : Periodendauer;
N : Anzahl der Abtastwerte pro Periodendauer;
n : Nummer des Abtastwertes nach Fehlereintritt;
$L_{ref}$ : Induktivität der Leitung von der Messstelle zur Referenzstelle;
$R_{ref}$ : Resistanz der Leitung von der Messstelle zur Referenzstelle;

- die Berechnung der momentanen Vergleichsspannungswerte gemäß folgender Gleichung erfolgt:

$$u_V(n) = \Delta u_f(n) - L_{ref}\frac{\Delta i_f(n) - \Delta i_f(n-1)}{T} - R_{ref} \cdot \Delta i_f(n) \,,$$

mit

$u_V(n)$ : momentaner Vergleichsspannungswert;
$\Delta u_f(n)$ : momentaner Delta-Spannungswert nach Fehlereintritt;
$\Delta i_f(n)$ : momentaner Delta-Stromwert nach Fehlereintritt;
$L_{ref}$ : Induktivität der Leitung von der Messstelle zur Referenzstelle;
$R_{ref}$ : Resistanz der Leitung von der Messstelle zur Referenzstelle;
T : Periodendauer;
n : Nummer des Abtastwertes nach Fehlereintritt;

- die momentanen Delta-Spannungswerte gemäß der folgenden Gleichung ermittelt werden:

$$\Delta u_f(n) = u(n) - u_p(n)$$

mit

$\Delta u_f(n)$ : momentaner Delta-Spannungswert nach Fehlereintritt;
u(n) : momentaner Spannungsabtastwert nach Fehlereintritt;
$u_p(n) = u(n-N)$ : Vorfehler-Spannungsabtastwert eine Periodendauer vor dem momentanen Spannungsabtastwert u(n);

n : Nummer des Abtastwertes nach Fehlereintritt;
N : Anzahl der Abtastwerte pro Periodendauer

und
- die momentanen Delta-Stromwerte gemäß der folgenden Gleichung ermittelt werden:

$$\Delta i_f(n) = i(n) - i_p(n)$$

mit

$\Delta i_f(n)$ : momentaner Delta-Stromwert nach Fehlereintritt;
$i(n)$ : momentaner Stromabtastwert nach Fehlereintritt;
$i_p(n) = i(n-N)$ : Vorfehler-Stromabtastwert eine Periodendauer vor dem momentanen Stromabtastwert $i(n)$;
n : Nummer des Abtastwertes nach Fehlereintritt;
N : Anzahl der Abtastwerte pro Periodendauer, und wobei

- die Berechnung des gleichgerichteten Referenzspannungswertes gemäß folgender Gleichung erfolgt:

$$U_{ref}(n) = \frac{2}{N} \sum_{k=n-(\frac{N}{2}-1)}^{n} \left(|u_{ref}(k)|\right),$$

mit

$U_{ref}(n)$ gleichgerichteter Referenzspannungswert;
$u_{ref}(k)$ : momentaner Referenzspannungswert für den Abtastwert k;
n Nummer des Abtastwertes nach Fehlereintritt;
N : Anzahl der Abtastwerte pro Periodendauer;
k : Aufsummierungsindex

und
- die Berechnung des gleichgerichteten Vergleichsspannungswertes gemäß folgender Gleichung erfolgt:

$$U_V(n) = \frac{2}{N} \sum_{k=n-(\frac{N}{2}-1)}^{n} \left(|u_V(k)|\right)$$

mit

$U_V(n)$ : gleichgerichteter Vergleichsspannungswert;
$u_V(k)$ : momentaner Vergleichsspannungswert für den Abtastwert k;
n : Nummer des Abtastwertes nach Fehlereintritt;
N Anzahl der Abtastwerte pro Periodendauer;
k : Aufsummierungsindex.

2. Verfahren nach Anspruch 1,
**dadurch gekennzeichnet, dass**

- als Referenzstelle (18) das Ende einer von dem Schutzgerät (12a) überwachten Überwachungszone (17) auf der Leitung (10) verwendet wird.

3.  Verfahren nach Anspruch 1 oder 2,
    **dadurch gekennzeichnet, dass**

    - das Schutzgerät (12a) den Beginn eines Kurzschlusses (16) erkennt, wenn die aufgenommenen Stromabtastwerte einen Stromsprung aufweisen, der einen Sprungschwellenwert übersteigt;
    - ein erstes Anregesignal erzeugt wird, wenn das Schutzgerät (12a) den Beginn eines Kurzschlusses (16) erkannt hat; und
    - das Schutzgerät (12a) erst nach Vorliegen des ersten Anregesignals mit der Fehlerauswertung der Strom- und Spannungsabtastwerte beginnt.

4.  Verfahren nach Anspruch 3,
    **dadurch gekennzeichnet, dass**

    - das Schutzgerät (12a) bei vorliegendem ersten Anregesignal zunächst eine Untersuchung der Strom- und Spannungsabtastwerte dahingehend durchführt, hinsichtlich welcher Phasenleiter der Leitung (10) der Kurzschluss (16) aufgetreten ist;
    - ein zweites Anregesignal erzeugt wird, das zumindest einen von dem Kurzschluss (16) betroffenen Phasenleiter angibt; und
    - das Schutzgerät (12a) die Fehlerauswertung nur hinsichtlich des zumindest einen von dem zweiten Anregesignal angegebenen Phasenleiters durchführt.

5.  Verfahren nach einem der vorangehenden Ansprüche,
    **dadurch gekennzeichnet, dass**

    - der Auslöseschwellenwert derart dynamisch festgelegt wird, dass mit steigender Anzahl der für die Berechnung des gleichgerichteten Vergleichsspannungswertes herangezogenen Strom- und Spannungsabtastwerte der Wert des Auslöseschwellenwertes zumindest in Stufen abnimmt.

6.  Verfahren nach einem der vorangehenden Ansprüche,
    **dadurch gekennzeichnet, dass**

    - die momentanen Strom- und Spannungsabtastwerte auch dazu verwendet werden, einen komplexen Impedanzwert der von dem Schutzgerät (12a) überwachten Leitung (10) zu berechnen; und
    - von dem Schutzgerät (12a) ein zweites einen Kurzschluss (16) auf der Leitung (10) angebendes Fehlersignal erzeugt wird, wenn der komplexe Impedanzwert innerhalb eines vorgegebenen Auslösegebietes in der komplexen Ebene liegt.

7.  Verfahren nach Anspruch 6,
    **dadurch gekennzeichnet, dass**

    - das Schutzgerät (12a) ein Auslösesignal zur Auslösung eines die Leitung (10) begrenzenden Leistungsschalters (11a) erzeugt, sobald das erste oder das zweite Fehlersignal vorliegt.

8.  Schutzgerät (12a) zur Überwachung einer Leitung (10) eines mehrphasigen elektrischen Energieversorgungsnetzes mit geerdetem Sternpunkt hinsichtlich auf der Leitung (10) auftretender Kurzschlüsse (16),
    **dadurch gekennzeichnet, dass**

    - das Schutzgerät (12a) zur Durchführung eines Verfahrens gemäß einem der Ansprüche 1 bis 7 eingerichtet ist.

**Claims**

1.  Method for detecting a short circuit (16) on a line (10) of a multi-phase electrical energy supply network with earthed neutral, wherein the following steps are carried out:

    - recording of current and voltage sampled values at a measurement point (15a) at one end (A) of the monitored line (10) by an electrical protection device (12a); and
    - generation of a first fault signal indicating a short circuit (16) on the line (10) if a fault evaluation of the current and voltage sampled values performed by the electrical protection device (12a) indicates a short circuit (16) present on the line(10);

**characterized in that**

- the following steps are performed for fault evaluation of the current and voltage sampled values:

  - calculation of instantaneous reference voltage values for a reference point (18) on the line (10) from instantaneous current and voltage sampled values recorded before the occurrence of the short circuit (16);
  - calculation of instantaneous comparative voltage values for the reference point (18) on the line (10) from instantaneous current and voltage sampled values recorded before the occurrence of the short circuit (16) and instantaneous current and voltage sampled values recorded during the short circuit (16);
  - calculation of a rectified reference voltage value from consecutive instantaneous reference voltage values and a rectified comparative voltage value from consecutive instantaneous comparative voltage values;
  - comparison of the rectified reference voltage value and the rectified comparative voltage value; and
  - generation of the first fault signal if the difference of the equivalent comparative voltage value and the rectified reference voltage value exceeds a triggering threshold value wherein,

- the instantaneous reference voltage values are calculated by the following equation:

$$u_{ref}(n) = u_p(n) - L_{ref}\frac{i_p(n)-i_p(n-1)}{T} - R_{ref} \cdot i_p(n),$$

where

$u_{ref}(n)$ :instantaneous reference voltage value;
$u_p(n) = u(n-N)$ :pre-fault voltage sampled value a period before the instantaneous voltage sampled value $u(n)$ ;
$i_p(n) = i(n-N)$ :pre-fault current sampled value a period before the instantaneous current sampled value $i(n)$;
T :period;
N :number of sampled values per period;
n :number of the sampled value after fault occurrence;
$L_{ref}$ :inductance of the line from the measurement point to the reference point;
$R_{ref}$ :resistance of the line from the measurement point to the reference point;

- the instantaneous comparative voltage values are calculated by the following equation:

$$u_v(n) = \Delta u_f(n) - L_{ref}\frac{\Delta i_f(n)-\Delta i_f(n-1)}{T} - R_{ref} \cdot \Delta i_f(n),$$

where

$u_v(n)$ :instantaneous comparative voltage value;
$\Delta u_f(n)$ :instantaneous delta voltage value after fault occurrence;
$\Delta i_f(n)$ :instantaneous delta current value after fault occurrence;
$L_{ref}$ :inductance of the line from the measurement point to the reference point;
$R_{ref}$ :resistance of the line from the measurement point to the reference point;
T :period;
n :number of the sampled value after fault occurrence;

- the instantaneous delta voltage values are established by the following equation:

$$\Delta u_f(n) = u(n) - u_p(n)$$

where

$\Delta u_f(n)$ :instantaneous delta voltage value after fault occurrence;
u(n) :instantaneous voltage sampled value after fault occurrence;
$u_p(n)= u(n-N)$ :pre-fault voltage sampled value, a period before the instantaneous voltage sampled value u(n);
n :number of the sampled value after fault occurrence;
N :number of the sampled values per period,

and
- the instantaneous delta current values are established by the following equation:

$$\Delta i_f(n)=i(n)-i_p(n)$$

where

$\Delta i_f(n)$ :instantaneous delta current value after fault occurrence;
i(n) :instantaneous current sampled value after fault occurrence;
$i_p(n)= i(n-N)$ :pre-fault current sampled value a period before the instantaneous current sampled value i(n);
n :number of the sampled value after fault occurrence;
N :number of the sampled values per period, and wherein

- the rectified reference voltage value is calculated by the following equation:

$$U_{ref}(n) = \frac{2}{N} \sum_{k=n-(\frac{N}{2}-1)}^{n} \left(|u_{ref}(k)|\right),$$

where

$U_{ref}(n)$ :rectified reference voltage value;
$u_{ref}(k)$ :instantaneous reference voltage value for the sampled value k;
n :number of the sampled value after fault occurrence;
N :number of sampled values per period;
k :summation index,

and
- the rectified comparative voltage value is calculated in accordance with the following equation:

$$U_v(n) = \frac{2}{N} \sum_{k=n-(\frac{N}{2}-1)}^{n} \left(|u_v(k)|\right)$$

where

$U_v(n)$ :rectified comparative voltage value;
$u_v(k)$ :instantaneous comparative voltage value for the sampled value k;
n :number of the sampled value after fault occurrence;
N :number of sampled values per period;
k :summation index.

2. Method according to Claim 1,

**characterized in that**

- the end of a monitoring zone (17) on the line (10) monitored by the protection device (12a) is used as the reference point (18).

3. Method according to Claim 1 or 2,
**characterized in that**

- the protection device (12a) detects the start of a short circuit (16) when the recorded current sampled values have a current jump that exceeds a jump threshold value;
- a first initiation signal is generated when the protection device (12a) has detected the start of a short circuit (16); and
- the protection device (12a) only starts the fault evaluation of the current and voltage sampled values once the first initiation signal is present.

4. Method according to Claim 3,
**characterized in that**

- with the presence of a first initiation signal the protection device (12a) first examines the current and voltage sampled values to establish which phase conductor of the line (10) is affected by the short circuit (16);
- a second initiation signal is generated that indicates at least one phase conductor affected by the short circuit (16); and
- the protection device (12a) performs the fault evaluation merely with regard to the at least one phase conductor indicated by the second initiation signal.

5. Method according to one of the preceding claims,
**characterized in that**

- the triggering threshold value is dynamically determined in such a way that the value of the triggering threshold value decreases at least in steps with an increasing number of the current and voltage sampled values used to calculate the rectified comparative voltage value.

6. Method according to one of the preceding claims,
**characterized in that**

- the instantaneous current and voltage sampled values are also used to calculate a complex impedance value of the line (10) monitored by the protection device (12a); and
- a second fault signal indicating a short circuit (16) on the line (10) is generated by the protection device (12a) if the complex impedance value lies within a predefined triggering area in the complex plane.

7. Method according to Claim 6,
**characterized in that**

- as soon as the first or the second fault signal is present the protection device (12a) generates a trigger signal to trigger a power circuit breaker (11a) defining the line (10).

8. Protection device (12a) for monitoring a line (10) of a multi-phase electrical energy supply network with earthed neutral for short circuits (16) occurring on the line (10),
**characterized in that**

- the protection device (12a) is adapted to perform a method according to one of Claims 1 to 7.

**Revendications**

1. Procédé de détection d'un court-circuit ( 16 ) sur une ligne ( 10 ) d'un réseau d'alimentation en énergie électrique polyphasé ayant un point étoile à la terre, dans lequel on effectue les stades suivants :

- on enregistre par un appareil ( 12a ) électrique de protection des valeurs d'échantillonnage de courant et de tension en un point ( 15a ) de mesure à une extrémité ( 16 ) de la ligne ( 10 ) contrôlée ; et
- on produit un premier signal de défaut indiquant un court-circuit ( 16 ) sur la ligne ( 10 ) si une évaluation de défaut, effectuée par l'appareil ( 12a ) électrique de protection, sur les valeurs d'échantillonnage de courant et de tension indique un court-circuit ( 16 ) présent sur la ligne ( 10 ) ;

**caractérisé en ce que**

pour l'évaluation de défaut sur les valeurs d'échantillonnage de courant et de tension, on effectue les stades suivants :

- on calcule des valeurs instantanées de tension de référence pour un point ( 18 ) de référence sur la ligne ( 10 ) à partir des valeurs d'échantillonnage instantanées de courant et de tension enregistrées avant l'apparition du court-circuit ( 16 ),
- on calcule des valeurs instantanées de tension de comparaison pour le point ( 18 ) de référence sur la ligne ( 10 ) à partir de valeurs d'échantillonnage instantanées de courant et de tension enregistrées avant l'apparition du court-circuit ( 16 ) et de valeurs d'échantillonnage instantanées de courant et de tension enregistrées pendant le court-circuit ( 16 ) ;
- on calcule une valeur redressée de tension de référence à partir de valeurs instantanées de tension de référence qui se succèdent et une valeur redressée de tension de comparaison à partir de valeurs instantanées de tension de comparaison qui se succèdent ;
- on compare la valeur redressée de tension de référence et la valeur redressée de tension de comparaison ; et
- on produit le premier signal de défaut, si la différence entre la valeur redressée de tension de comparaison et la valeur redressée de tension de référence dépasse une valeur de seuil de déclenchement, dans lequel
- on effectue le calcul des valeurs instantanées de tension de référence selon l'équation suivante :

$$u_{ref}(n) = u_p(n) - L_{ref}\frac{i_p(n) - i_p(n-1)}{T} - R_{ref} \cdot i_p(n),$$

avec

$U_{ref}( n )$ : Valeur instantanée de tension de référence,
$U_p( n ) = u( n-N )$ : Valeur d'échantillonnage de tension avant défaut, une période avant la valeur $u( n )$ d'échantillonnage instantanée de tension ;
$i_p(n) = i( n-N )$ : Valeur d'échantillonnage de courant avant défaut, une période avant la valeur $i( n )$ d'échantillonnage instantanée de courant ;
$T$ : durée d'une période ;
$N$ : Nombre des valeurs d'échantillonnage par période ;
$n$ : Numéro de la valeur d'échantillonnage après l'apparition d'un défaut ;
$L_{ref}$ : Inductance de la ligne du point de mesure au point de référence ;
$R_{ref}$ : Résistance de la ligne du point de mesure au point de référence ;

- on calcule les valeurs instantanées de tension de comparaison suivant l'équation suivante :

$$u_V(n) = \Delta u_f(n) - L_{ref}\frac{\Delta i_f(n) - \Delta i_f(n-1)}{T} - R_{ref} \cdot \Delta i_f(n),$$

avec

$U_v( n )$ : Valeur instantanée de tension de comparaison ;
$\Delta u_f( n )$ : Valeur instantanée de tension delta après l'apparition du défaut ;
$\Delta i_f( n )$ : Valeur instantanée de courant delta après l'apparition du défaut :
$L_{ref}$ : Inductance de la ligne du point de mesure au point de référence ;
$R_{ref}$ : Résistance de la ligne du point de mesure au point de référence ;
$T$ : durée d'une période ;
$n$ : Numéro de la valeur d'échantillonnage après l'apparition du défaut ;

- on détermine les valeurs instantanées de tension delta selon l'équation suivante :

$$\Delta u_f(n) = u(n) - u_p(n)$$

avec

$\Delta u_f(n)$ : Valeur instantanée de tension delta après l'apparition du défaut ;
$u(n)$ : Valeur instantanée d'échantillonnage de tension après l'apparition du défaut ;
$U_p(n) = u(n-N)$ : Valeur d'échantillonnage de tension avant défaut, une période avant la valeur $u(n)$ instantanée d'échantillonnage de tension ;
$n$ : Numéro de la valeur d'échantillonnage après l'apparition du défaut ;
$N$ : Nombre des valeurs d'échantillonnage par période ;

et

- on détermine les valeurs instantanées de courant delta selon l'équation suivante :

$$\Delta i_f(n) = i(n) - i_p(n)$$

avec

$\Delta i_f(n)$ : Valeur instantanée de courant delta après l'apparition du défaut :
$i(n)$ : Valeur instantanée d'échantillonnage du courant après l'apparition du défaut ;
$i_p(n) = i(n-N)$ : Valeur d'échantillonnage du courant avant défaut, une période avant la valeur $i(n)$ d'échantillonnage instantanée de courant ;
$n$ : Numéro de la valeur d'échantillonnage après l'apparition du défaut ;
$N$ : Nombre des valeurs d'échantillonnage par période ; et dans lequel

- on effectue le calcul de la valeur redressée de tension de référence suivant l'équation suivante :

$$U_{ref}(n) = \frac{2}{N} \sum_{k=n-(\frac{N}{2}-1)}^{n} \left( \left| u_{ref}(k) \right| \right),$$

avec

$U_{ref}(n)$ : Valeur redressée de tension de référence ;
$U_{ref}(k)$ : Valeur instantanée de tension de référence pour la valeur k d'échantillonnage ;
$n$ : Numéro de la valeur d'échantillonnage après après l'apparition du défaut ;
$N$ : Nombre des valeurs d'échantillonnage par période ;
$k$ : Indice de sommation

et

- on effectue le calcul de la valeur redressée de tension de comparaison selon l'équation suivante :

$$U_V(n) = \frac{2}{N} \sum_{k=n-(\frac{N}{2}-1)}^{n} \left( \left| u_V(k) \right| \right)$$

avec

$U_v( n )$ : Valeur redressée de tension de comparaison ;

$U_v( k )$ : Valeur instantanée de tension de comparaison entre la valeur k d'échantillonnage ;

n : Numéro de la valeur d'échantillonnage après après l'apparition du défaut ;

N : Nombre des valeurs d'échantillonnage par période ;

k : Indice de sommation.

2. Procédé suivant la revendication 1,
**caractérisé en ce que**

- on utilise comme point ( 18 ) de référence l'extrémité d'une zone ( 17 ) sur la ligne ( 10 ) de contrôle, contrôlée par l'appareil ( 12a ) de protection.

3. Procédé suivant la revendication 1 ou 2,
**caractérisé en ce que**

- l'appareil ( 12a ) de protection détecte le début d'un court-circuit ( 16 ) si les valeurs enregistrées d'échantillonnage de courant ont un saut de courant qui dépasse une valeur de seuil de saut ;
- on produit un premier signal d'excitation si l'appareil ( 12a ) de protection a détecté le début d'un court-circuit ( 16 ) ; et
- l'appareil ( 12a ) de protection ne commence à évaluer le défaut des valeurs d'échantillonnage de courant et de tension qu'après la présence du premier signal d'excitation.

4. Procédé suivant la revendication 3,
**caractérisé en ce que**

- l'appareil ( 12a ) de protection effectue, en présence du premier signal d'excitation, d'abord une analyse des valeurs d'échantillonnage de courant et de tension en ce qui concerne le conducteur de phase de la ligne ( 10 ) sur lequel le court-circuit ( 16 ) est apparu ;
- on produit un deuxième signal d'excitation qui indique au moins un conducteur de phase concerné par le court-circuit ( 16 ) ; et
- l'appareil ( 12a ) de protection effectue l'évaluation du défaut seulement en ce qui concerne le au moins un conducteur de phase indiqué par le deuxième signal d'excitation.

5. Procédé suivant l'une des revendications précédentes,
**caractérisé en ce que**

- on fixe dynamiquement la valeur de seuil de déclenchement de manière à ce qu'au fur et à mesure qu'augmente le nombre des valeurs d'échantillonnage de courant et de tension mises à profit pour le calcul de la valeur redressée de tension de comparaison, la valeur du seuil de déclenchement diminue au moins par degré.

6. Procédé suivant l'une des revendications précédentes,
**caractérisé en ce que**

- on utilise aussi les valeurs instantanées d'échantillonnage de courant et de tension pour calculer une valeur d'impédance complexe de la ligne ( 10 ) contrôlée par l'appareil ( 12a ) de protection ; et
- on produit par l'appareil ( 12a ) de protection un deuxième signal de défaut indiquant un court-circuit ( 16 ) sur la ligne ( 10 ) si la valeur d'impédance complexe se trouve dans le plan complexe dans un domaine de déclenchement donné à l'avance.

7. Procédé suivant la revendication 6,
**caractérisé en ce que**

- l'appareil ( 12a ) de protection produit un signal de déclenchement pour le déclenchement d'un disjoncteur ( 11a ) bornant la ligne ( 10 ) dès qu'il y a le premier ou le deuxième signal de défaut.

8. Appareil ( 12a ) de protection pour le contrôle d'une ligne ( 10 ) d'un réseau d'alimentation en énergie électrique polyphasé ayant un point étoile mis à la terre en ce qui concerne des courts-circuits ( 16 ) se produisant sur la ligne ( 10 ),

**caractérisé en ce que**

- l'appareil ( 12a ) de protection est agencé pour effectuer un procédé suivant l'une des revendications 1 à 7.

## FIG 1

# FIG 2

## FIG 3

30a

$u_A$

t=0

30b

$u_{p, A}$

t=0

30c

$\Delta u_{f, A}$

t=0

## FIG 4

40

31

T

32

$\Delta u_{f, A}$

$u_A$

$u_{p, A}$

t=0

# FIG 5

**FIG 6**

**FIG 7**

**FIG 8**

$I_{\varphi\psi}$

$I^*_{1-2}$
$I_{1-2}$
84
81

$I^*_{2-3}$
$I_{2-3}$
82

$I^*_{3-1}$
$I_{3-1}$
85
83

t

**FIG 9**

u, i → 91 → 92 → 93 → $S_{an2}$

$S_{an1}$

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2008187825 A